# EUROPEAN PATENT APPLICATION

(11) **EP 0 892 501 A1**
(43) Date of publication of application: **20.01.1999**
(21) Application number: 98305547.6
(22) Date of filing: 13.07.1998
(51) Int. Cl.: H03M 13/22

(54) **Convolutional interleaver and convolutional de-interleaver**

(30) Priority: 18.07.1997 GB 9715239
(71) Applicant: NOKIA MOBILE PHONES LTD., 02150 Espoo (FI)
(72) Inventor: Westman, Tapani, 90100 Oulu (FI); Laukkanen, Mika, 90520 Oulu (FI)
(74) Representative: Style, Kelda Camilla Karen

(57) **Abstract**

A convolutional interleaver (30) has an input for receiving data to be interleaved. A memory (54) stores a plurality of bits of the received data. Reading means (56) read the bits of data out of the memory (54) such that the bits of data are interleaved. An output (31) outputs the interleaved data. Conventional convolutional interleavers have the drawback that, in an initialization phase, empty memory locations are read and meaningless bits are outputted owing to the fact that data bits have not yet been written in said memory locations. The disclosed interleaver alleviates this problem with means for preventing data present into the memory other than the received data from being output via the output (31) data present in the memory (54) means other than the received data from being output via the output (31).

## Description

The present invention relates to a convolutional interleaver and an interleaving method for use in a telecommunications network such as a cellular telecommunications network. The present invention also relates to the corresponding de-interleaver and de-interleaving method.

In known telecommunication systems, burst errors which occur in a channel between a transmitter and a receiver can be spread by interleaving the data prior to its transmission through the channel. The receiver attempts to correct the errors after de-interleaving by for example using a Viterbi algorithm or more generally with some error correcting decoder. Typically, this interleaving will take place in an interleaver in the transmitter after the data has been encoded and prior to its modulation. The receiver is provided with a de-interleaver which would typically be between a demodulator and a decoder. The de-interleaver will reverse the steps carried out by the interleaver in the transmitter from which the data has been received.

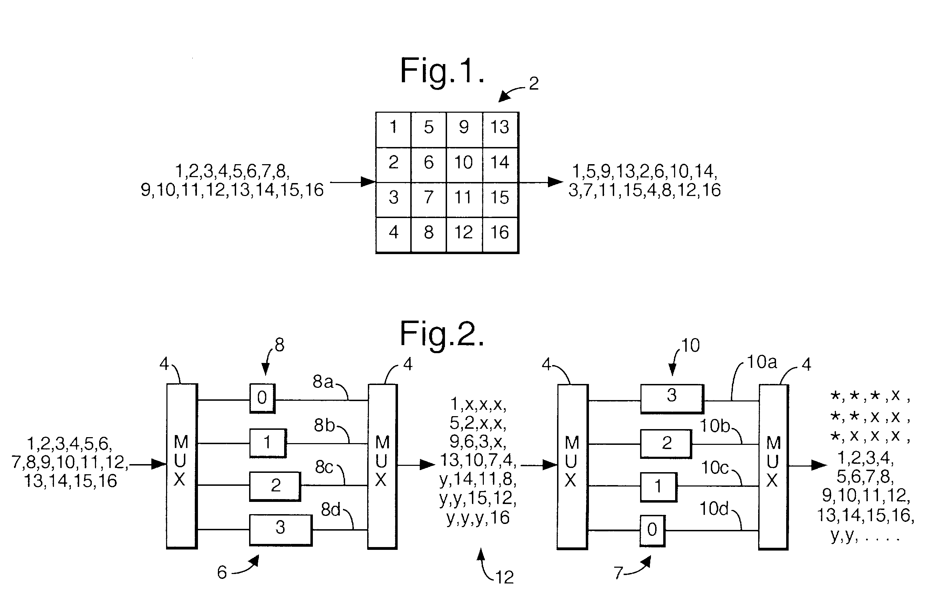

Block interleaving is one type of interleaving which is widely used. Block interleaving is used in digital cellular (mobile) telecommunication networks. To explain the principles of block interleaving, reference will now be made to Figure 1 which illustrates a random access memory (RAM) which is typically used in a block interleaver in the transmitter. A similar RAM is provided in the receiver and makes up the de-interleaver. Consecutive symbols from, for example, an encoder, are input into the memory 2 by columns. In Figure 1, the consecutive symbols from the encoder are shown as 1, 2, 3, 4, 5 .... 16. The memory 2 is then read out to a modulator by rows. As illustrated in Figure 1, the data is read out of the memory 2 in a different order to the order in which it enters the memory 2. In particular, the order in which the data is read out is 1, 5, 9, 13, 2, 6 etc in the example shown in Figure 1. In the receiver which receives the encoded interleaved and modulated data via the channel, the output from the demodulator is input into a memory of the de-interleaver by rows and read out by columns in order to de-interleave the data.

The output of the memory 2 of the interleaver shown in Figure 1 indicates the order of the data as it is transmitted through the channel between the transmitter and the receiver. Accordingly, if the first four transmitted symbols (1,5,9 and 13) were corrupted by a channel error burst, the symbols which are received by the receiver after deinterleaving will be such that the affected symbols are spaced apart by four symbols. This makes it easier to remove or compensate for the effect of the burst of channel errors in the decoding of the error correction coded input data. The errors may be removed or compensated for by using, for example, a Viterbi algorithm.

A second method of interleaving which has been proposed is convolutional interleaving. However, to date, convolutional interleaving has not been employed in cellular telecommunication networks. Reference will now be made to Figures 2 to 4. Figure 2 illustrates a typical convolutional interleaver 6 and the corresponding de-interleaver 7. The interleaver 6 and the de-interleaver 7 each have two multiplexers 4. All of the multiplexers 4 in the interleaver 8 and the de-interleaver 10 are arranged to operate synchronously. The interleaver 6 and de-interleaver 7 each have a memory 8 and 10 respectively comprising a plurality of rows 8a-d and 10a-d. Each interleaver 8 and de-interleaver memory row 8a-d and 10a-c is a shift register memory with a varying number of units of delay. The switches of the first multiplexer 4 of the interleaver 6 change position after each symbol time so that successive bits from, for example, the output of the encoder, are written in different rows 8a-d of the memory 8 of the interleaver 6. The first symbol input to the first multiplexer 4 of the interleaver 6 enters the top row 8a of the interleaver memory 8 which has no delay, is transmitted over the channel 12 immediately and enters the top row 10a of the de-interleaver memory 10 which has, in the particular example shown, three units of delay. The second multiplexer 4 of the interleaver 6 is arranged to ensure that successive bits to be transmitted over the channel 12 are taken from successive rows of the memory 8. The symbols received by the de-interleaver 7 will of course pass through the first multiplexer 4 of the de-interleaver 7 which controls to which row of the memory the symbols are written. The second symbol input to the first multiplexer 4 of the interleaver enters the second row 8b of the interleaver memory 8 and is delayed by one delay unit before it is transmitted across the channel 12. When the second symbol has been transmitted across the channel 12, it is input via the first multiplexer 4 of the de-interleaver 7 to the second row 10b of the de-interleaver memory 10 and has a delay of two units. The third and fourth rows 8c and 8d of the interleaver memory 8 have delays of two and three units respectively. The third and fourth rows 10c and 10d of the de-interleaver memory have one and zero units of delay respectively. Thus, successive inputs to the first multiplexer 4 of the interleaver 6 are transmitted across the channel four symbols apart in the example shown and therefore would not be effected by the same error burst. It should be appreciated that all symbols have the same delay after passing both through the interleaver 6 and the de-interleaver 7 so that the symbols are output from the second multiplexer 4 of the de-interleaver in the same order as they are input to the first multiplexer 4 of the interleaver 6.

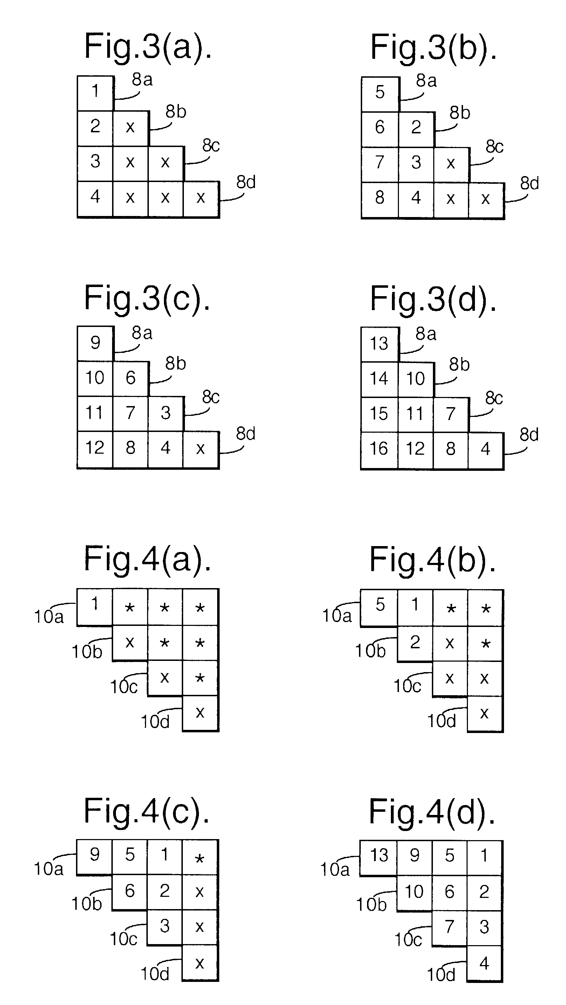

Reference will now be made to Figures 3 and 4 which show in more detail the data flow in the interleaver 6 and the de-interleaver 7. Each row shown in Figures 3 and 4 represents one row 8a-d or 10a-d of the interleaver memory 8 or de-interleaver memory 10 respectively. Figure 3a shows the configuration of the interleaver memory 8 when four symbols (1,2,3,4) have been input from the encoder. Figure 3b shows the interleaver memory when eight symbols have been input (one of the symbols having already been read out). Likewise, Figures 3c and 3d show the interleaver memory 8 after twelve and sixteen symbols respectively have been input to the interleaver memory 8. Again, some of the symbols have already been read out of the interleaver memory 8. When the interleaver memory 8 is in the state shown in Figure 3a, the second multiplexer 4 of the interleaver 6 will cause the following symbols to be read from successive rows 8a-d of the memory 8 and transmitted across the channel in the following order: 1,x,x,x where x represents unknown data which is already present in the interleaver memory 8 when the interleaver is first used. When the memory 8 is in the state shown in Figure 3b, the following symbols will be transmitted in the following order: 5,2,x,x. In a similar manner, the symbols will be read out of memory 8 when it is in the states shown in Figures 3c and 3d. Thus, the complete output of the second multiplexer 4 of. the interleaver 6 is as follows:
1,x,x,x,5,2,x,x,9,6,3,x,13,10,7,4,y,14,11,8,y,y,15,12,y,y,y,16.
y represents the data following the first 16 symbols or unknown data which is in the memory 8 if no new data is read into the memory 8 after the 16 symbols have been received from the encoder.

The first multiplexer 4 of the de-interleaver 7 writes the data received via the channel into successive rows of the memory 10. Figure 4 shows the de-interleaver memory 10. Figure 4a shows the de-interleaver memory 10 when the first four symbols from the interleaver 6 have been received. Figure 4b shows the de-interleaver memory when eight symbols have been received from the interleaver 6 whilst Figure 4c and 4d show the de-interleaver memory 10 when twelve and sixteen symbols respectively have been received. * represents unknown data which is already present in the de-interleaver memory 10 when it is first used, x being the unknown and unnecessary data from the interleaver 6. The second multiplexer 4 of the de-interleaver will read the symbols out of successive rows of the memory. The output from the de-interleaver memory 10, when in the state shown in Figure 4a is *,*,*,x. The output of the interleaver memory 10 when in the state shown in Figure 4b will be *,*,x,x,. Similarly, the data will be read out of the memory 10 when it is, in the states shown in Figures 4c and 4d. The output of the second multiplexer 4 of the de-interleaver 7 will be as follows:
*,*,*,x,*,*,x,x,*,x,x,x,1,2,3,4,5,6,7,8,9,10,11,12,13,14,15,16 ,y....

The convolutional interleaver has advantages over the block interleaver in that a much smaller memory capacity is required in order to get the same performance (for example bit error ratio) as with a block interleaver. In particular only half the memory capacity would be required in order to achieve the same results as a block interleaver. This means that the delay caused by interleaving can be reduced significantly if a convolutional interleaver is used. In particular, the delay is only half that which occurs if a block interleaver is used. In other words, the same performance can be achieved in a convolutional interleaver with half the delay, as compared to a block interleaver.

Alternatively, for a convolutional interleaver having the same memory capacity as a block interleaver, a significantly greater time diversity can be achieved. In particular, twice the time diversity can be achieved. However, the inventors have appreciated that there is a problem with convolutional interleavers. As discussed in relation to Figures 2 to 4 unknown and unnecessary data is transmitted across the channel 12. This is disadvantageous in that more data than is necessary will initially be sent through the channel. The inventors have also appreciated that this is a particular disadvantage of systems that use discontinuous transmission (DTX). The DTX mode is proposed to be used in third generation cellular systems. In code division multiple access (CDMA) systems, the DTX mode may be used to reduce the amount of interference which is a limiting factor on the capacity of CDMA systems. The DTX mode is used in some second generation cellular systems such as for example GSM. Each time the convolutional interleaver is first used, the unknown and unnecessary data will undesirably be transmitted across the channel.

It is therefore an aim of embodiments of the present invention to avoid these difficulties in convolutional interleavers.

According to one aspect of the present invention, there is provided a convolutional interleaver comprising an input for receiving data to be interleaved; memory means for storing a plurality of bits of said received data; means for reading said bits of data out of said memory means such that said bits of data are interleaved; an output for outputting said interleaved data; and means for preventing data present in said memory means other than said received data from being output via said output.

By incorporating preventing means in said convolutional interleaver, the problem of unknown and unnecessary data being transmitted across the channel can be avoided. Thus, embodiments of the present invention may be suitable for systems using a discontinuous transmission mode.

Preferably, the preventing means comprises control means which are arranged to control the reading means such that only said data input via said input means is read out of said memory. The preventing means may comprise control means for controlling the order in which data is written into said memory. Thus, the convolutional interleaver can be arranged to prevent unnecessary data from being output by controlling the order in which data is written into the memory and/or controlling the order in which data is read out of the memory. In one preferred embodiment of the present invention, the control means is arranged to ensure that the memory means is completely filled with data to be interleaved before any data is read out of said memory means.

Alternatively or additionally, the preventing means may comprise data removing means arranged between the reading means and said output, said data removing means being arranged to remove data other than said input data from the data read out of the memory means. Again, this provides a simple method for ensuring that unnecessary data is not transmitted through the channel.

Preferably, the input is arranged to receive a discontinuous flow of data.

The interleaver may be arranged so that the preventing means is arranged to operable when the interleaver is first used and/or when the data is first received after an interruption or transmission pause. The preventing means may be arranged to be operable with respect to an end of a stream of received data. With the known convolutional interleavers, problems occur at the beginning and end of a stream of data which results in unnecessary bits being transmitted across the channel. Embodiments of the present invention are able to prevent these problems from occurring.

Preferably, the interleaver is incorporated into a transmitter for use in a cellular telecommunications network. The interleaver may be in a digital signal processor or in an application specific integrated circuit (ASIC).

According to a second aspect of the present invention, there is provided a convolutional de-interleaver comprising an input for receiving interleaved data to be de-interleaved; memory means for storing a plurality of bits of said interleaved data; means for reading said bits of data out of said memory such that said bits of data are de-interleaved; an output for outputting said de-interleaved data; and means for preventing data present in said memory means other than said received data from being output via said output.

The preventing means prevents data present in the memory means other than the received data from being output via said memory means. This can be advantageous in certain embodiments of the present invention.

According to a third aspect of the present invention, there is provided a convolutional de-interleaver for use with a convolutional interleaver as discussed hereinbefore comprising an input for receiving interleaved data to be de-interleaved; memory means for storing a plurality of bits of said data; means for reading said bits of data out of said memory such that said bits of data are de-interleaved; an output for outputting said de-interleaved data; and means for compensating for the effects of said preventing means of said convolutional interleaver.

Thus, an interleaver embodying the present invention can also be used with a de-interleaver embodying the present invention so as to overcome the difficulties of the known interleavers.

The compensating means may comprise a controller for controlling the order in which received data is written in to said memory and/or the order in which data is read out of said memory by said reading means. Thus, the operations performed by the convolutional de-interleaver can be reversed by the de-interleaver.

Preferably, the de-interleaver is incorporated in a receiver for use in a cellular telecommunications network. The de-interleaver may be incorporated in a digital signal processor or in an application specific integrated circuit (ASIC).

A mobile station may incorporate a transmitter and/or a receiver as discussed above. Likewise, the base transceiver station may incorporate a transmitter and/or a receiver as discussed hereinbefore.

According to a further aspect of the present invention, there is provided a method of convolutional interleaving comprising inputting data to be interleaved; storing a plurality of bits of said received data; reading said bits of data out of said memory means thereby interleaving said data;
preventing stored data other than said received data from being output; and
outputting the interleaved data.

According to a further aspect of the present invention, there is provided a method of de-interleaving comprising receiving interleaved data to be de-interleaved; storing a plurality of bits of said interleaved data; reading out bits of said stored data such that said bits of data are de-interleaved; preventing said stored data other than said received data from being output; and outputting the de-interleaved data.

According to a further aspect of the present invention, there is provided a method of de-interleaving for use with the method of interleaving discussed above comprising receiving interleaved data to be de-interleaved; storing a plurality of bits of said data; reading out said stored bits of data such that the bits of data are de-interleaved; compensating for the effects of said preventing step of said convolutional interleaving method; and outputting said de-interleaved data.

For a better understanding of the present invention and as to how the same may be carried into effect, reference will now be made by way of example to the accompanying drawings in which:-
Figure 1 shows a conventional block interleaver;
Figure 2 shows a conventional convolutional interleaver and de-interleaver;
Figure 3 shows the contents of the interleaver memory of the interleaver shown in Figure 2;
Figure 4 shows the contents of the memory of the de-interleaver shown in Figure 2;
Figure 5 shows a typical cellular telecommunications network;
Figure 6 shows a block diagram of a transmitter in a base station or mobile station in which the convolutional interleaver embodying the present invention can be incorporated and a receiver in a mobile station or base station in which the de-interleaver embodying the present invention can be incorporated;
Figure 7 shows a first interleaver and de-interleaver according to the present invention;
Figure 8 shows the contents of the memory of the interleaver at Figure 7;
Figure 9 shows the contents of the memory of the de-interleaver of Figure 7; and
Figure 10 shows a second interleaver and de-interleaver embodying the present invention.

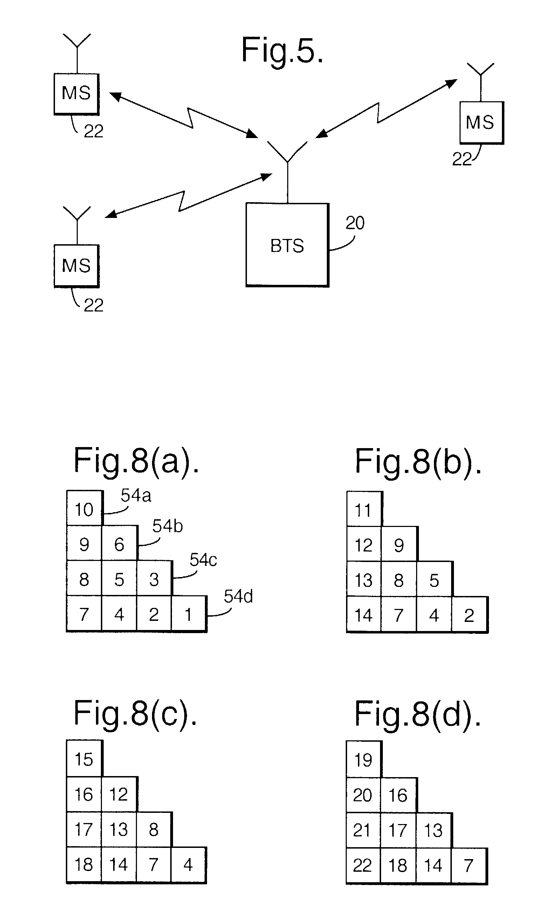

Figure 5 illustrates part of a cellular communication network in which the convolutional interleaver embodying the present invention can be used. Cellular telecommunication networks typically comprise a network of base stations 20, one of which is shown in Figure 5. Each base station 20 is arranged to transmit signals to and receive signals from the mobile stations 22. Likewise, each mobile station 22 is arranged to transmit signals to and receive signals from the base station 20. Generally, radio waves are used in the communications between the base stations 20 and the mobile stations 22.

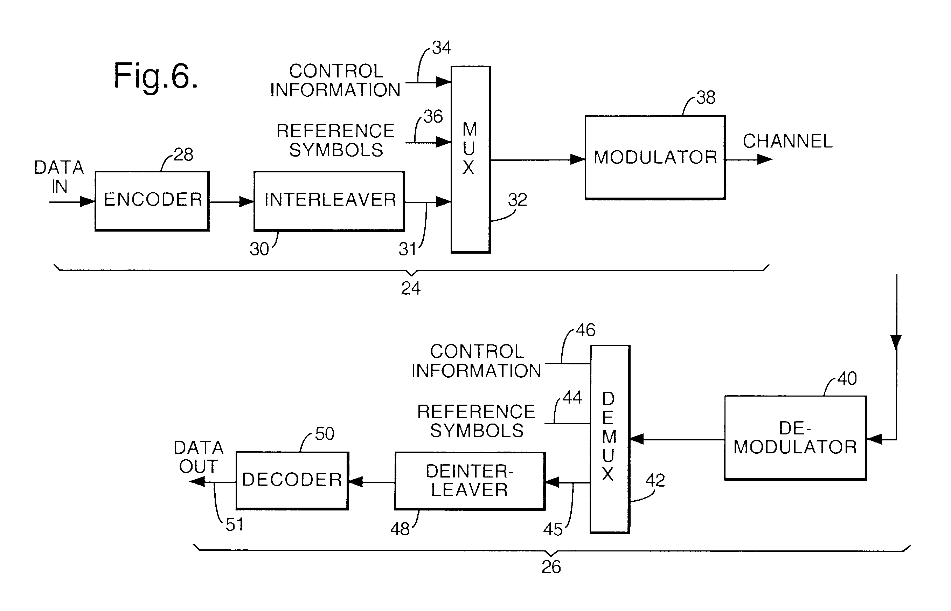

Reference will now be made to Figure 6 which schematically shows a transmitting circuit 24 and a receiving circuit 26. It should be appreciated that each mobile station will have a receiving circuit 24 and a transmitting circuit 26. Likewise, each base station 20 will also have a transmitting circuit 24 and a receiver circuit 26. In the block diagram illustrated in Figure 6, the transmitting circuit 24 will either be in a mobile station 22 or a base transceiver station 20. The receiving circuit 26 will be in the base transceiver station 20 or the mobile station 22 respectively.

The transmitting circuit 24 will first be described. The transmitting circuit 24 has an encoder 28 which receives data. The data may be a stream of bits or symbols. That data can represent a speech signal, a video signal or a data signal and will generally be referred to as "data". The input data is encoded by the encoder 28. The encoding technique used by the encoder 28 will depend on the specification of the cellular communication network of which the transmitting circuit 24 forms a part. The encoded signal generated by the encoder 28 is output to a interleaver 30 which interleaves the data. In embodiments of the present invention, this interleaver is a convolutional interleaver. This interleaver 30 will be described in more detail hereinafter. The interleaver 30 thus provides an output 31 which consists of the encoded and interleaved data. That output 31 is connected to an input of a multiplexer 32. The multiplexer 32 is also arranged to receive an input 34 which provides control information and an input 36 which provides reference symbols or the like. The output of the multiplexer 32 provides a signal which can include the encoded and interleaved data as well as reference symbols or the like and control information. The signal output from the multiplexer 32 is input to a modulator 38 which modulates the signal. The duly modulated signal is placed onto a carrier wave and is transmitted through the channel. The channel is generally defined by the air medium between a mobile station and a base station or vice versa.

The receiving circuit 26 will now be described. The signal which is transmitted across the channel is received by the receiver circuit 26 and input to a demodulator 40. The demodulator 40 removes the carrier wave component and demodulates the received signal. The demodulated signal is input to a demultiplexer 42 which divides the received signal into three parts. In particular, the demultiplexer 42 separates the data from the reference symbols which are output via output 44 and the control information which is output via output 46. The data output from the demultiplexer 42 via output 45 is input to a de-interleaver 48 which performs the reverse operation to that carried out by the interleaver 30. The data which is output by the de-interleaver 48 is still encoded but no longer interleaved and is therefore input into a decoder 50. The data is then decoded and output via output 51.

It should be appreciated that the block diagram shown in Figure 6 is schematic and does not include all the various stages which in practice would be present in mobile stations 22 and base transceiver stations 20.

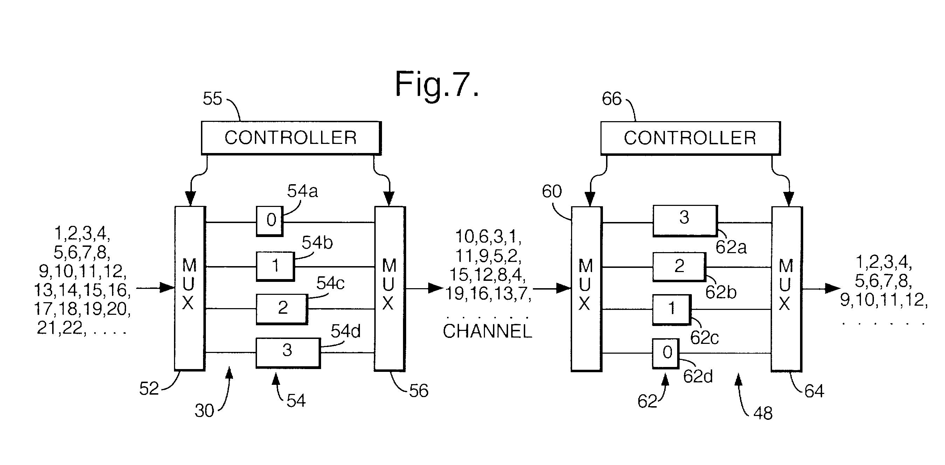

Reference will now be made to Figure 7 which illustrates an interleaver 30 embodying the present invention and a de-interleaver 48 embodying the present invention. The interleaver 30 is a convolutional interleaver which has a similar structure to the known convolutional interleaver illustrated in Figure 2. The interleaver 30 has a first multiplexer 52 which is arranged to receive data from the encoder 28. For the purpose of describing the embodiment of the present invention, the data input to the convolutional interleaver 30 will be considered as a sequence of n successive bits. However, in actual embodiments of the present invention, the input data may be a sequence of n symbols. The first multiplexer 52 is controlled by a controller 55 which controls the operation of the switches of the multiplexer 52. In the prior art convolutional interleaver described in relation to Figure 2, each successive bit is written into successive rows of the memory. However, in the embodiment of the present invention described in relation to Figure 7, the controller 55 is able to control using the multiplexer 52 which row a given bit is to be written. Thus successive bits of data may not always be written into successive rows of a memory 54.

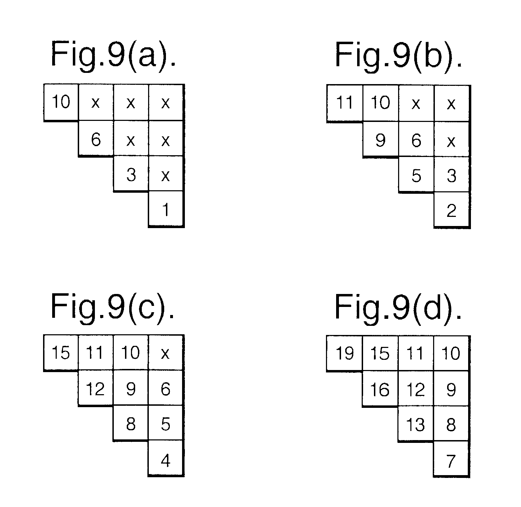

As with the prior art convolutional interleaver, the interleaver 30 embodying the present invention has a plurality of rows 54a-d of memory 54. Each row 54a-d of the memory 54 acts as a shift register and has a different delay associated therewith. Accordingly the first row 54a of the memory 54 has no delay. This means that a bit written into that row 54a will be immediately read out. The second row 54b has one unit of delay. This means that the bit read into that row 54b of the memory 54 will be the second bit to be read out of that row of the memory 54. In the arrangement illustrated in Figure 7, the third row 54c of memory would have two units of delay whilst the fourth row 54d of the memory would have three units of delay. In this regard, reference is made to Figure 8 which shows the contents of the memory 54 of the convolutional interleaver shown in Figure 7. Each row 54a-d illustrated in Figure 8 corresponds to one row 54a-d of the memory 54. Figures 8a-8d show successive states of the interleaver memory 54 after every four new bits have been written to the memory 54. In other words, Figure 8b shows the state of the memory 54 after four new bits have been written into the memory 54 as compared to Figure 8a. Similarly, Figure 8c shows the memory after a further four bits have been written into the memory as compared to the state shown in Figure 8b. There is a similar relationship between Figures 8c and 8d.

The multiplexer 52 is controlled by the controller 55 to cause the memory 54 to be filled up completely before any of the data to be transmitted needs to be read out of the memory 54. In the specific embodiment shown in Figure 8a, the first two bits are both written into the fourth line 54d of the memory. The third bit is written into the third row 54c of the memory whilst the fourth bit is written into the fourth row 54d of the memory. The fifth and sixth bits are written into the third row 54c and second row 54b respectively of the memory 54. The seventh, eighth, ninth and tenth bits are written into the fourth, third, second and first rows 54d-a respectively. Only once the interleaver 54 has been completely filled with data to be transmitted is the second multiplexer 56 enabled by the controller 55 in order to read out the data in a conventional manner starting with the first row of the interleaver 54a. Thus, the unnecessary or undesired bits which occupy the memory 54 of the interleaver 30 prior to the receipt of any data would be shifted out of the memory 54 by the incoming data and would not be read out of the memory by the second multiplexer 56.

The second multiplexer 56 of the interleaver 30 when activated by the controller 55 would read the data out of the interleaver memory in a conventional manner. In particular, the second multiplexer 56 would successively switch to read the data from each row 54a-d in turn of the memory of the interleaver 30. Thus, the second multiplexer 56 would first take data from the first row 54a of the memory 54 followed by the oldest data in row 54b, the oldest data from the third row 54c and the oldest data from row 54d. The multiplexer would then go back to the first row 54a of the memory 54 in order to read out the next piece of data and so on.

As can be seen from Figure 8a, the first four bits of data to be read out will be: 10, 6, 3, 1. From Figure 8b, it can be seen that the second four bits of data to be read out will be: 11, 9, 5, 2. From Figures 8c and 8d it can be seen that the next eight bits of data to be read out will be: 15, 12, 8, 4, 19, 16, 13, 7 and so on. The bits which are read out of the memory 54 by multiplexer 56 will be transmitted through the channel (after modulation).

As can be seen from a consideration of Figures 7 and 8, no unnecessary or unwanted bits of data are thus transmitted through the channel.

Figure 7 also illustrates a de-interleaver 48 which is arranged to reverse the operation carried out by the interleaver 30. The de-interleaver 48 comprises a first multiplexer 60 which receives (after demodulation) the data transmitted through the channel. The multiplexer 60 is arranged to control the order in which the data is read into the memory 62 of the de-interleaver 48. As with the interleaver 30, the memory 62 of the de-interleaver 48 comprises a plurality of rows 62a-d of memory each of which acts as a shift register and each of which has a specific delay associated therewith. The data which is received from the first row 54a of the memory 54 of the interleaver 30 is also'stored in the first row 62a of the memory 62 of the de-interleaver 48. However, the first row 62a of the memory 62 of the de-interleaver has three units of delay. The data from the second row 54b of the interleaver memory 54 is read into the second row 62b of the memory 62 of the de-interleaver 48. The second row 62b of the de-interleaver 48 has a delay of two units. Likewise, the contents of the third and fourth rows 54c and 54d of the interleaver memory 54 are read into the third and fourth rows 62c and 62d of the de-interleaver memory 62 respectively with delays of one and zero units respectively. As with the prior art, the total delay for any one bit is constant taking into consideration the delay provided by the interleaver 30 and the de-interleaver 48 and is equivalent to three units of a delay in the illustrated example.

Figure 9 illustrates the successive states of the de-interleaver memory 62 after each additional four bits have been received. In particular, Figure 9a shows the de-interleaver memory 6 after four bits have been received. Figure 9b shows the de-interleaver memory 62 after eight bits have been received, and Figures 9c and 9d show the de-interleaver memory 62 after twelve and sixteen bits have been received. x represents the previous contents of the de-interleaver memory 62.

The de-interleaver 48 is provided with a second multiplexer 64 which is controlled by a controller 66. In a similar manner to the first multiplexer 52 of the interleaver 30, the second multiplexer 64 is controlled to the ensure that none of the unknown and unwanted bits of data are read out of the memory 62 and that the de-interleaving operation can be successfully carried out. Accordingly, the reverse operation to that carried out by the first multiplexer 52 of the interleaver under the control of its controller 55 is carried out. In particular, the multiplexer 64 is controlled by the controller 66 to read the first two successive bits out of the fourth row 62d of the interleaver memory 62, that is bits 1 and 2 (see Figure 9a and 9b). The second multiplexer 64 is then controlled to read out the oldest bit from the third row 62c (bit 3) of the de-interleaver memory followed the oldest bit from the fourth 62d, third 62c, and second 62b rows of the interleaver memory 62 (bits 4, 5, 6). Once the first six bits have been read out of the de-interleaver memory 62, the second multiplexer 64 is then controlled to operate in a conventional manner reading out in succession from the fourth, third, second and first rows of the memory.

The controller 66 is also arranged to control when the multiplexer 60 should start writing data into the memory 62.

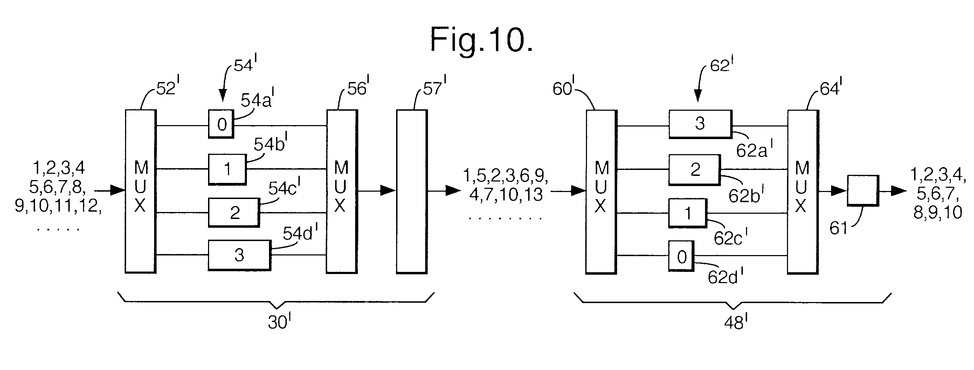

The second convolutional interleaver 30' and de-interleaver 48' embodying the present invention will now be described in relation to Figure 10. The interleaver 30' of the interleaver shown in Figure 10 comprises a first multiplexer 52' and a second multiplexer 56'. Between the multiplexers 52' and 56' is arranged an interleaver memory 54' which has rows 54' a-d of memory 54'. The part of the interleaver 30' defined by the first and second multiplexers 52' and 56' and the interleaver memory 54' operates in the same way as known interleavers and in this regard, reference is made to the description in relation to Figures 2 to 4. However, the second convolutional interleaver 30' embodying the present invention includes an additional element 57 which acts as a data removing block. The data removing block 57 is arranged to determine when the beginning of a transmission occurs. Once the beginning of a transmission has been located, the data removing block 57 is arranged to remove the undesired or unnecessary bits of data which were in the interleaver memory 54' before the data was received by the interleaver 30'. For example, with the conventional convolutional interleaver as shown in Figure 2, the first four bits of data to be transmitted across the channel would be 1,x,x,x. However, the data removing block 57 is arranged to remove the second, third, and fourth bits so that only the first bit of data, 1, is transmitted across the channel. Likewise, the seventh, eighth and twelfth bits which are all x are not transmitted across the channel. These bits again correspond to undesired data. Thus, if a data stream of consecutive bits of 1,2,3.... were input to the convolutional interleaver shown in Figure 10, the following will be transmitted through the channel: 1, 5, 2, 9, 6, 3, 13... .

The de-interleaver 48' embodying the present invention has a first multiplexer 60', a second multiplexer 64' and an interleaver memory 62' with a plurality of rows 62a'-62d' and has a similar construction to that of a conventional de-interleaver. However, a controller 61 is provided in order to correctly deinterleave the data and effectively carries out a similar operation to that carried out by the data removing element 57.

The function of controller 61, can in certain embodiments of the invention be provided by the de-interleaving algorithm. The controller 61 is arranged to ensure that any unwanted bits of data present in the de-interleaver memory 62', which are read out by the second multiplexer 64', are removed from the stream of data read out from de-interleaver memory 62'. In addition, the order in which data is read out of the memory 62' is controlled by controlling the order in which the second multiplexer reads the data of the interleaver. This is so that the received data can be correct. Thus, when the data is de-interleaved, the sequence will be correctly de-interleaved.

In one modification to this embodiment, the multiplexer 60' is controlled by a controller, similar to that shown in relation to Figure 7 which controls which row of the de-interleaver memory 62' the receive data is read into so that the data can be correctly de-interleaved.

It should be appreciated that in relation to the embodiments of the invention described hereinbefore, the rows of the interleaver and de-interleaver memories have been described as being particularly applicable to the case where a new stream of data has been received by the transmitter circuit. Thus, embodiments of the present invention are particularly applicable to discontinuous transmission methods where there are delays between consecutive transmissions. It should be appreciated that in the embodiments of the present invention, the various interleavers may return to the same mode of operation used by conventional interleavers once the first few bits of data have been received so that the interleaver memory is full of user data and any unnecessary data has either been removed from the memory in the case of the first embodiment or has been read out of the memory in the case of the second embodiment.

The particular order in which the data is read out from the interleaver memory in the first embodiment can be any suitable order and not just the method shown in the embodiment illustrated in relation to Figure 7. However, it should be ensured where possible that adjacent bits of received data are generally separated by a minimum number of bits when transmitted across the channel in order to achieve the advantages of interleaving.

The present invention is also applicable to the case where the last bits of a data stream are being read out of the interleaver memory. For example, the unknown bits of information indicated by y in relation to Figure 2 could represent unwanted data. The controller 55 can control the multiplexer 56 to ensure that the unwanted data at the end of a message is not read out and subsequently transmitted through the channel. Likewise, in relation to the second embodiment of the invention described in relation to Figure 9, the data removal block 57 can be arranged to prevent the transmission of the unwanted data at the end of the data stream through the channel. In those circumstances, the data removing block 57 may be arranged to receive a signal from a controller which is able to determine the end of the data stream. Once the data removing block 57 has received the end of data stream signal, the data removing block 57 is able to remove the undesired bits y so that no undesired or unnecessary bits are transmitted through the channel. The controller 61 could carry out a similar function to the data removing block but at the de-interleaver.

It should be noted that in some embodiments of the present invention, the interleaver/de-interleaver is configurable to change the required memory size in dependence on the application of the interleaver/de-interleaver. Embodiments of the present invention are particularly applicable to the situation where the size of the interleaver memory is changed from being the first size to a second larger size. In the embodiments described hereinbefore, the interleaving and de-interleaving memories are shown as having a generally triangular configuration. However, embodiments of the invention may include other configurations for the memories. For example, the memories may have a truncated triangular shape or the like. The configuration of the memories will depend for example on the length of each discontinuous transmission.

Embodiments of the present invention are applicable to all digital cellular communication networks, and can be used with any of the existing standards, such as GSM, DCS 1800, IS-95, IS-136, PDC etc. Additionally, the present invention can also be used with CDMA (code division multiple access) based systems which are currently being developed.

The convolutional interleaver and de-interleaver embodying the present invention can be included in any suitable location within the base transceiver station or mobile station. For example, the interleaver and/or de-interleaver can be provided in the digital signal processor or alternatively may be implemented in ASIC circuit (application specific integrated circuit).

Embodiments of the present invention are particularly suitable for discontinuous transmission situations such as voice activated links etc.

The memories are described as being shift registers. However, it should be appreciated that the memory can have only suitable construction and may, for example, be a suitable configured RAM.

The multiplexers 32 and 34 are optional items and in some embodiments of the present invention may be omitted. The presence or absence of these multiplexers will depend on the system specification and/or the standard used.

## Claims

1. A convolutional interleaver comprising:
an input for receiving data to be interleaved;
memory means for storing a plurality of bits of said received data;
means for reading said bits of data out of said memory means such that said bits of data are interleaved;
an output for outputting said interleaved data; and
means for preventing data present in said memory means other than said received data from being output via said output.

2. An interleaver as claimed in claim 1, wherein said preventing means comprises control means which are arranged to control the reading means such that only said data input via said input means is read out of said memory means.

3. An interleaver as claimed in claim 1 or 2, wherein said preventing means comprises control means for controlling the order in which data is written into said memory means.

4. An interleaver as claimed in claim 2 or 3, wherein said control means is arranged to ensure that the memory means is completely filled with data to be interleaved before any data is read out of said memory means.

5. An interleaver as claimed in any one of the preceding claims, wherein said preventing means comprises data removing means arranged between said reading means and said output, said data removing means being arranged to remove data other than said input data from the data read out of the memory means.

6. An interleaver as claimed in any preceding claim, wherein said input is arranged to receive a discontinuous flow of data.

7. An interleaver as claimed in any preceding claim, wherein said preventing means is arranged to be operable when said interlever is first used and/or when data is first received after an interruption.

8. An interleaver as claimed in any preceding claim, wherein said preventing means is arranged to be operable with respect to an end of a stream of received data.

9. An interleaver as claimed in any preceding claim, wherein switching means are arranged between said input and said memory to allow said received data to be read to respective locations in said memory means.

10. A transmitter for use in a cellular telecommunications network incorporating an interleaver as claimed in any preceding claim.

11. A transmitter as claimed in claim 10, wherein said interleaver is incorporated in a digital signal processor.

12. A transmitter as claimed in claim 10, wherein said interleaver is incorporated in an application specific integrated circuit.

13. A convolutional de-interleaver for use with a convolutional interleaver as claimed in any one of claims 1 to 9 comprising:
an input for receiving interleaved data to be de-interleaved;
memory means for storing a plurality of bits of said data;
means for reading said bits of data out of said memory such that said bits of data are de-interleaved;
an output for outputting said de-interleaved data; and
means for compensating for the effects of said preventing means of said convolutional interleaver.

14. A de-interleaver as claimed in claim 13 wherein said compensating means comprises a controller for controlling the order in which the received data is written into said memory.

15. A de-interleaver as claimed in claim 13 or 14 wherein said compensating means comprises means for controlling the order in which data is read out of said memory by said reading means.

16. A de-interleaver as claimed in any of claims 13 to 15 wherein switching means are arranged between said input and said memory to allow said received data to be read to respective locations in said memory means.

17. A de-interleaver as claimed in any of claims 13 to 16, wherein means for preventing data present in said de-interleaving memory other than said received data from being output are provided.

18. A receiver for use in a cellular telecommunications network incorporating a de-interleaver as claimed in any of claims 13 to 19.

19. A receiver as claimed in claim 18, wherein said de-interleaver is incorporated in a digital signal processor.

20. A receiver as claimed in claim 18, wherein said de-interleaver is incorporated in an application specific integrated circuit.

21. A mobile station incorporating a transmitter and/or a receiver as claimed in any one of claims 10, 11, 12, 18, 19 or 20.

22. A base transceiver station incorporating a transmitter and/or a receiver as claimed in any of claims 10, 11, 12, 18, 19 or 20.

23. A method of convolutional interleaving comprising:
inputting data to be interleaved;
storing a plurality of bits of said received data;
reading said bits of data out of said memory means thereby interleaving said data;
preventing stored data other than said received data from being output; and
outputting the interleaved data.

24. A method of de-interleaving for use with the method of interleaving as claimed in claim 23 comprising:
receiving interleaved data to be de-interleaved;
storing a plurality of bits of said data;
reading out said stored bits of data such that the bits of data are de-interleaved;
compensating for the effects of said preventing step of said convolutional interleaving method; and
outputting said de-interleaved data.
